Europäisches Patentamt

European Patent Office

Office européen des brevets

(11) Numéro de publication: **0 368 741**
**A1**

## (12) DEMANDE DE BREVET EUROPEEN

(21) Numéro de dépôt: **89403052.7**

(22) Date de dépôt: **07.11.89**

(51) Int. Cl.⁵: **H01L 23/498, H01L 23/64**

(30) Priorité: **08.11.88 FR 8814541**

(43) Date de publication de la demande:
**16.05.90 Bulletin 90/20**

(84) Etats contractants désignés:
**CH DE ES FR GB IT LI NL SE**

(71) Demandeur: **BULL S.A.**
**121, Avenue de Malakoff**
**F-75116 Paris(FR)**

(72) Inventeur: **Dehaine, Gérard**
**25, avenue de la Grande Armée**
**F-75016 Paris(FR)**

(74) Mandataire: **Denis, Hervé et al**
**BULL S.A. Industrial Property Department**
**P.C.: HQ 8M006 P.B. 193.16 121 avenue de**
**Malakoff**
**F-75764 Paris Cédex 16(FR)**

(54) Support de circuit intégré et son procédé de fabrication, circuit intégré adapté au support et boîtiers en résultant.

(57) Des pattes d'alimentation 13a de l'ensemble 14 des pattes du support TAB 10 sont reliées entre elles au-dessus du circuit intégré 11 par un pont conducteur 22.

FIG. 1

EP 0 368 741 A1

## Support de circuit intégré et son procédé de fabrication, circuit intégré adapté au support et boîtiers en résultant.

L'invention se rapporte à un support TAB (Tape-Automated Bonding) d'un circuit intégré, appelé encore puce ou chip, à un procédé de fabrication du support, à un circuit intégré adapté au support ainsi qu'à des boîtiers résultant de la mise en oeuvre du support et du circuit intégré conformes à l'invention.

Les circuits intégrés actuels ordinaires sont des plaquettes semiconductrices sensiblement carrées, d'environ un centimètre de côté et pouvant porter jusqu'à 500 bornes périphériques. Le support TAB d'un tel circuit intégré comprend un substrat isolant porteur d'une pluralité de pattes rayonnantes, appelée araignée TAB. Le substrat est ordinairement fait d'un matériau plastique souple, tel que celui connu sous la marque déposée Kapton, et se compose d'un ou plusieurs cadres concentriques. Les pattes du support convergent vers une région centrale du substrat pour être connectées aux bornes d'entrée-sortie du circuit intégré selon une opération appelée ILB (Inner Lead Bonding), consistant ordinairement en un soudage par thermocompression. Le support TAB d'un circuit intégré est habituellement découpé d'un film de type cinématographique, appelé film TAB. comprenant une succession longitudinale d'araignées TAB et de perforations latérales servant à déplacer et à positionner le film.

L'un des problèmes actuels de l'encapsulation d'un circuit intégré de haute densité dans un boîtier concerne l'alimentation en énergie du circuit intégré. Les potentiels d'alimentation sont la masse et ordinairement une ou deux différentes valeurs prédéterminées. En cours de fonctionnement du circuit intégré, ces potentiels doivent rester stables en dépit des différentes valeurs d'intensité du courant demandé par les circuits appelés à fonctionner dans le circuit intégré. De ce fait, les pattes d'alimentation constituent autant de lignes de transmission électrique présentant une composante réactive d'auto-induction en réponse aux variations de courant. La composante d'auto-induction de chaque patte est donc proportionnelle à sa longueur. D'autre part, l'intensité du courant d'alimentation est actuellement élevée. Par exemple, certains circuits intégrés peuvent dissiper momentanément jusqu'à 6 watts sous une tension de 3 volts, nécessitant ainsi l'écoulement de deux ampères. Compte tenu de la grande densité des bornes du circuit intégré, les pattes doivent être étroites et très rapprochées les unes des autres. L'écoulement d'une forte intensité de courant d'alimentation doit donc se faire dans une pluralité de pattes d'alimentation. De surcroît, les faibles sections des pattes augmentent leur résistance ohmique.

La solution actuellement adoptée consiste à appliquer les potentiels d'alimentation sur des bornes massives respectives, extérieures au boîtier et connectées à l'intérieur de celui-ci à des plans conducteurs de potentiel respectifs. Les plans conducteurs sont associés à des condensateurs discrets de découplage, incorporés au boîtier. ou forment les plaques d'un condensateur de découplage. Ils sont aussi connectés aux pattes d'alimentation correspondantes, au plus près du circuit intégré. La longueur des pattes d'alimentation est ainsi réduite approximativement à la longueur séparant les bornes d'alimentation du circuit intégré des plans conducteurs avoisinants. Cette solution a donc l'avantage de réduire l'impédance ohmique et la composante réactive d'auto-induction du circuit d'alimentation dans le boîtier. Elle a cependant l'inconvénient de compliquer la structure du boîtier et de le rendre beaucoup plus cher.

L'invention propose une solution simple, efficace et bon marché pour disposer de plans conducteurs à proximité du circuit intégré. Ces plans conducteurs peuvent se substituer aux plans conducteurs du boîtier et faciliter ainsi la construction du boîtier, ou coopérer avec eux.

L'invention se rapporte à un support TAB d'un circuit intégré, comprenant une pluralité de pattes destinées à être connectées au circuit intégré dans une région du support, caractérisé en ce que parmi les pattes un premier groupe prédéterminé de pattes sensiblement inférieur à ladite pluralité est relié dans la région, en une position prévue au-dessus du circuit intégré, à un premier pont conducteur.

Avantageusement, un second pont conducteur est fixé par l'intermédiaire d'une couche d'isolation sur le premier pont conducteur précité et comporte des jambes pour être relié à un second groupe de pattes du support. Le circuit intégré coopère ainsi avec deux plans de potentiel constitués par les premier et second plans conducteurs, auxquels peut s'ajouter une capacité de découplage.

L'invention se rapporte aussi à un circuit intégré adapté au support à deux ponts conducteurs, comprenant des bornes d'alimentation et des bornes de signaux, caractérisé en ce que certaines bornes d'alimentation présentent chacune une surface permettant la connexion ILB et la fixation des jambes du second pont conducteur.

L'invention se rapporte encore à un procédé de fabrication du support de circuit intégré défini précédemment, comprenant la formation dans une feuille conductrice d'une pluralité de pattes convergeant dans une région pour être fixées au circuit intégré, caractérisé en ce qu'il consiste à prolonger dans la région un premier groupe de pattes et à les réunir dans la région à un pont conducteur.

L'invention concerne aussi un boîtier de circuit intégré monté sur un support TAB, comprenant au moins deux plans conducteurs de potentiel extérieurs au circuit intégré, caractérisé en ce que le support TAB est celui défini précédemment.

L'invention peut aboutir à une structure de boîtier plus simple et plus compacte, grâce à l'élimination possible de plans conducteurs de potentiel extérieurs au circuit intégré.

Il en résulte un boîtier de circuit intégré monté sur un support TAB, comprenant une embase supportant le circuit intégré et le support TAB, caractérisé en ce que le circuit intégré est celui défini précédemment et le support TAB est celui pourvu des deux ponts conducteurs et sur lequel la pluralité de pattes s'étend à l'extérieur du boîtier pour être connectées à des plages correspondantes d'une carte d'interconnexion.

Les caractéristiques et avantages de l'invention ressortiront de la description qui suit, donnée à titre d'exemple et faite en référence aux dessins annexés.

Dans les dessins :

- la figure 1 est une vue de dessus, avec suppression partielle des conducteurs de signaux et d'alimentation, d'un support TAB conforme à l'invention, pourvu d'un circuit intégré de haute densité et associé à un film TAB illustré partiellement ;

- la figure 2 est une vue en coupe suivant la ligne II-II du support représenté sur la figure 1 et incorporé dans un premier boîtier illustré, suivant la même coupe, dans sa position finale de montage sur une carte d'interconnexion ;

- la figure 3 est une vue de dessus similaire à celle de la figure 1, illustrant une région agrandie d'une variante de réalisation conforme à l'invention d'un support TAB et d'un circuit intégré adapté à ce support ;

- la figure 4 est une vue en coupe partielle selon la figure IV-IV du support et du circuit intégré représentés sur la figure 3 ;

- la figure 5 est une vue en coupe similaire à celle de la figure 4, illustrant une autre variante de réalisation d'un support TAB conforme à l'invention ; et

- la figure 6 est une vue en coupe d'un second boîtier conforme à l'invention incorporant le circuit intégré représenté sur les figures 3 et 4 et une variante d'exécution conforme à l'invention du support représenté sur la figure 5.

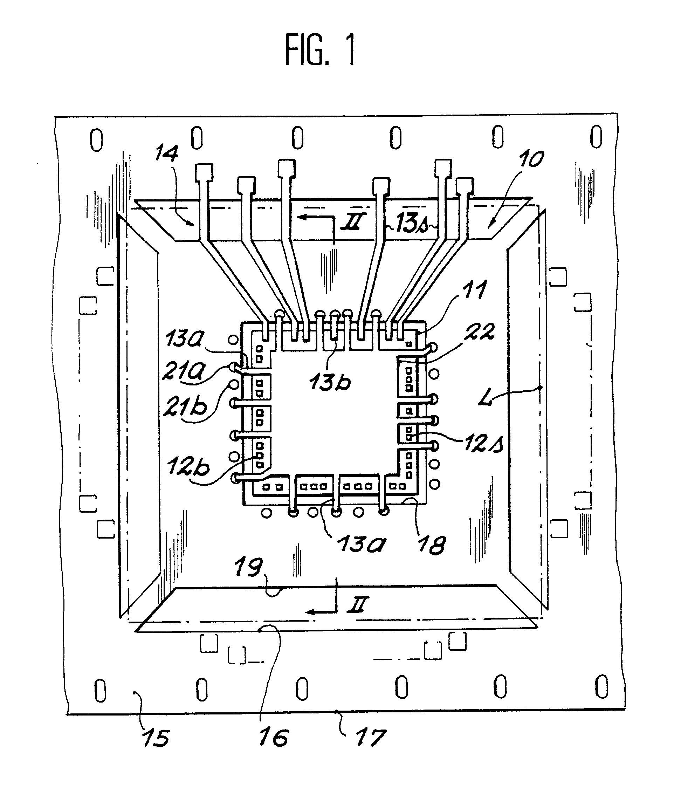

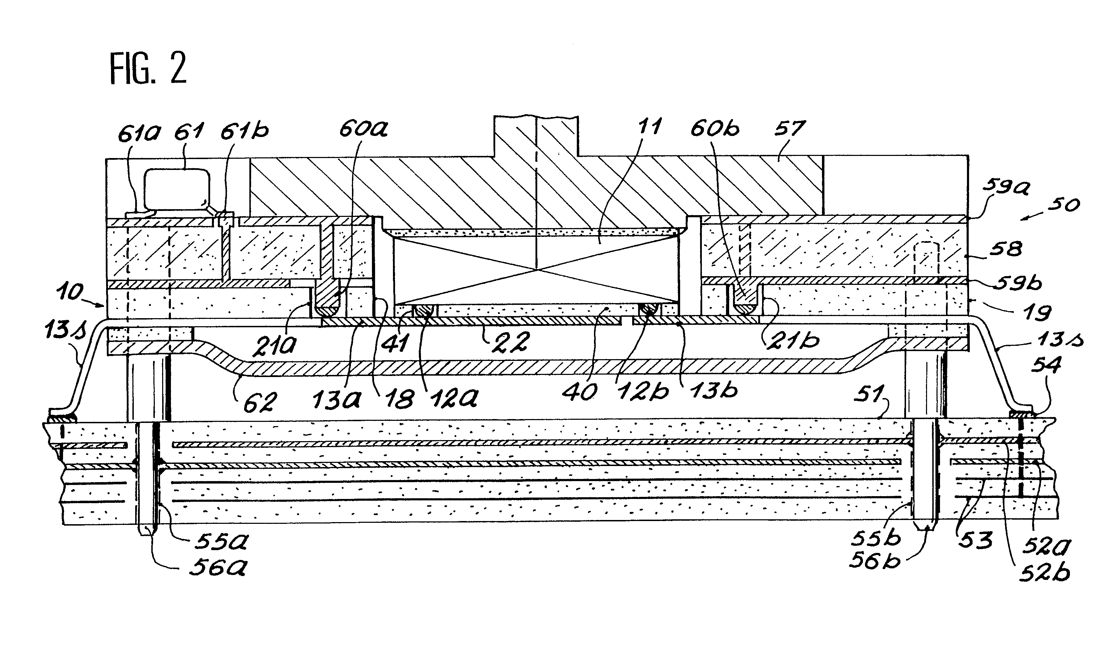

Les figures 1 et 2 illustrent un support TAB 10 conforme à l'invention, adapté à la connexion d'un circuit intégré de haute densité 11. Le circuit intégré 11 illustré dans les figures 1 et 2 est de type classique, formé sur une plaquette semiconductrice et pourvu de bornes périphériques d'entrée-sortie 12. Pour des raisons de commodité du dessin, le circuit intégré 11 représenté sur la figure 1 ne porte qu'un petit nombre de bornes d'entrée-sortie. Le support 10 illustré est de type classique, comprenant une pluralité de conducteurs 13 disposés en un faisceau appelé araignée TAB 14 et fixés sur une face d'un substrat 15 fait en un matériau souple et électriquement isolant. Le substrat 15 forme initialement un film TAB 17 de type cinématographique, pourvu de perforations latérales servant au déplacement et au positionnement du film. Sur le film 17, les conducteurs 13 forment les pattes de l'araignée 14, disposées en porte-à-faux autour d'une fenêtre 16 du substrat 15. De manière classique, le support 10 illustré dans la figure 2 a été découpé dans la fenêtre 16, suivant la ligne L en trait fantôme de la figure 1 et selon l'opération OLB (Outer Lead Bonding). Dans la fenêtre 16, les pattes 13 de l'araignée 14 sont portées par un cadre 19 solidaire du substrat 15. Le circuit intégré 11 est placé dans la région centrale 18 formée par les parois intérieures du cadre 19. De manière classique, le substrat 15 du film 17 est ordinairement préformé par découpage mécanique pour constituer la fenêtre 16 et le cadre 19 maintenu par des bras 20 alignés sur les diagonales de la fenêtre 16. Puis l'araignée TAB 14 est faite par gravure d'une feuille conductrice de cuivre ou d'aluminium préalablement collée sur le substrat préformé. Les extrémités intérieures des pattes 13 sont alors soudées, ordinairement par thermocompression, aux bornes 12 du circuit intégré 11.

L'araignée TAB 14 se compose de deux types de conducteurs, à savoir les conducteurs de signaux 13s connectés aux bornes de signaux respectives 12s du circuit intégré 11, et de conducteurs d'alimentation en énergie du circuit intégré 11. Les conducteurs d'alimentation se répartissent en autant de groupes que de potentiels d'alimentation. Dans l'exemple illustré dans les figures 1 et 2, le circuit intégré 11 est alimenté par ses bornes respectives 12a, 12b en deux potentiels d'alimentation Ua et Ub par l'intermédiaire de deux groupes 13a et 13b de pattes d'alimentation. Par exemple, les pattes 13a correspondent au potentiel de la masse Ua et les pattes 13b correspondent au potentiel Ub, de 3 volts par exemple. Dans la figure 1, les pattes de signaux 13s et les pattes d'alimentation 13b n'ont été représentées que sur un seul côté du circuit intégré, alors que toutes les pattes d'alimentation 13a ont été illustrées. Une particularité du support TAB 10 de l'exemple illustré est de présenter de longues pattes de signaux 13s et de très courtes pattes d'alimentation 13a, 13b interrompues au voisinage de trous correspondants 21a, 21b qui traversent le cadre 19 dans sa périphérie intérieure. Le support 10 tel que décrit précédemment est bien adapté à un boîtier de circuit intégré.

Le boîtier 50 représenté sur la figure 2 inclut le support 10 vu suivant la coupe médiane II-II de la figure 1. Dans la figure 2, le boîtier 50 est illustré en position finale de montage sur une carte d'interconnexion 51. La carte d'interconnexion 51 illustrée est du type carte de circuits imprimés, incorporant deux plans conducteurs 52a, 52b recevant respectivement les potentiels d'alimentation Ua et Ub et un réseau d'interconnexion de signaux 53 formé de deux niveaux représentés par un trait simple et relié par des piliers conducteurs (illustrés par un trait tireté) à une couronne périphérique de plages 54, extérieure et coaxiale au boîtier 50. Les plans 52a, 52b sont respectivement connectés à des trous métallisés 55a, 55b dans lesquels sont enfichées les extrémités de pieux 56a, 56b du boîtier 50. Dans le boîtier 50, le circuit intégré 11 est fixé sur une embase 57 faite en un matériau électriquement et thermiquement conducteur, tel que le cuivre ou l'aluminium. L'embase 57 illustrée est pourvue d'une colonne centrale pour la fixation d'un radiateur (non illustré). Les deux pieux 56a sont fixés perpendiculairement à l'embase 57 dans deux de ses coins. Le circuit intégré 11 est entouré d'un cadre isolant de découplage 58 portant sur ses deux grandes faces des plans conducteurs 59a, 59b correspondant respectivement aux potentiels Ua et Ub. Le plan conducteur 59a repose sur l'embase 57 en faisant contact électrique avec elle. Le cadre 19 du support 10 repose sur le plan conducteur 59b. Les trous 21a, 21b du cadre 19 viennent en correspondance avec des îlots respectifs 60a, 60b connectés électriquement (soudés par exemple) aux extrémités extérieures des pattes correspondantes 13a, 13b. Les îlots 60a sont en liaison avec le plan conducteur 59a par des piliers conducteurs traversant le cadre de découplage 58, tandis que les îlots 60b sont des extensions du plan conducteur 59b. Des condensateurs de découplage 61 sont disposés sur la périphérie extérieure du cadre de découplage 58 et ont chacun une borne 61a soudée au plan conducteur 59a et une borne 61b en liaison avec le plan conducteur 59b par l'intermédiaire d'un pilier conducteur traversant le cadre de découplage 58. Le cadre de découplage 58 porte dans deux coins les deux pieux 56b faisant contact avec le plan conducteur 59b. Les longues pattes de signaux 13s du support 10 sortent du boîtier 50 pour être fixées par soudage aux plages 54 de la carte 51. Le boîtier 50 est fermé par un couvercle 62. Le boîtier 50 pourrait aussi être du type décrit dans la demande de brevet européen n° 0 239 494.

L'invention s'applique au support 10. Selon l'invention, un premier pont conducteur 22 dans la région centrale 18 du cadre 19 réunit le groupe de pattes d'alimentation 13a. Dans l'exemple représenté sur les figures 1 et 2, les pattes d'alimentation 13a se prolongent vers l'intérieur de la région centrale 18, au-dessus du circuit intégré 11, pour être réunies par le pont conducteur 22 qui occupe la majeure partie de la région centrale 18. Le pont conducteur 22 permet ainsi le soudage ILB de toutes les pattes 13 de l'araignée 14.

Le procédé de fabrication d'un film TAB est bien adapté à la fabrication du pont conducteur 22. En effet, il suffit de le former par gravure en même temps que l'araignée 14. Par conséquent, un support 10 conforme à l'invention est remarquable en ce qu'un groupe de pattes 13a sensiblement inférieur au nombre de pattes de l'araignée 14 sont réunies par un pont conducteur 22. Ce pont peut recevoir diverses variantes conformes à l'invention. Par exemple, il peut porter une base isolante 40 (figure 2) destinée à venir en appui contre la face active du circuit intégré 11. Comme illustré, la base 40 s'étend avantageusement sur toute la face active du circuit intégré 11, en étant percée de trous 41 en correspondance avec les bornes 12 du circuit intégré 11 pour faire la soudure ILB de l'araignée 14. Etant donné qu'en pratique les extrémités intérieures des pattes d'une araignée TAB sont ordinairement réunies par une bande isolante destinée à assurer leur positionnement et percée de trous en correspondance avec toutes les bornes du circuit intégré, la réalisation de la base isolante 40 ne nécessite pas une opération supplémentaire dans le procédé de fabrication du film TAB conforme à l'invention. Il est aussi évident que le pont 22 peut avoir une forme annulaire au lieu de la plaquette pleine représentée sur les figures 1 et 2. De même, le support 10 peut être conformé différemment. Par exemple, les pattes d'alimentation peuvent être de longues pattes, ne coopérant pas avec des trous dans le cadre 19, comme les pattes de signaux 13s. D'autre part, l'invention est adaptée à tout mode de fabrication du film TAB 17. Par exemple, le film 17 peut être formé à partir d'une feuille de cuivre, d'abord gravée pour former les araignées 14 et les ponts 22, puis recouvertes du substrat 15 que l'on grave selon la configuration souhaitée. Dans ce cas, la base 40 pourrait être issue du substrat 15 et formée lors de la gravure du substrat.

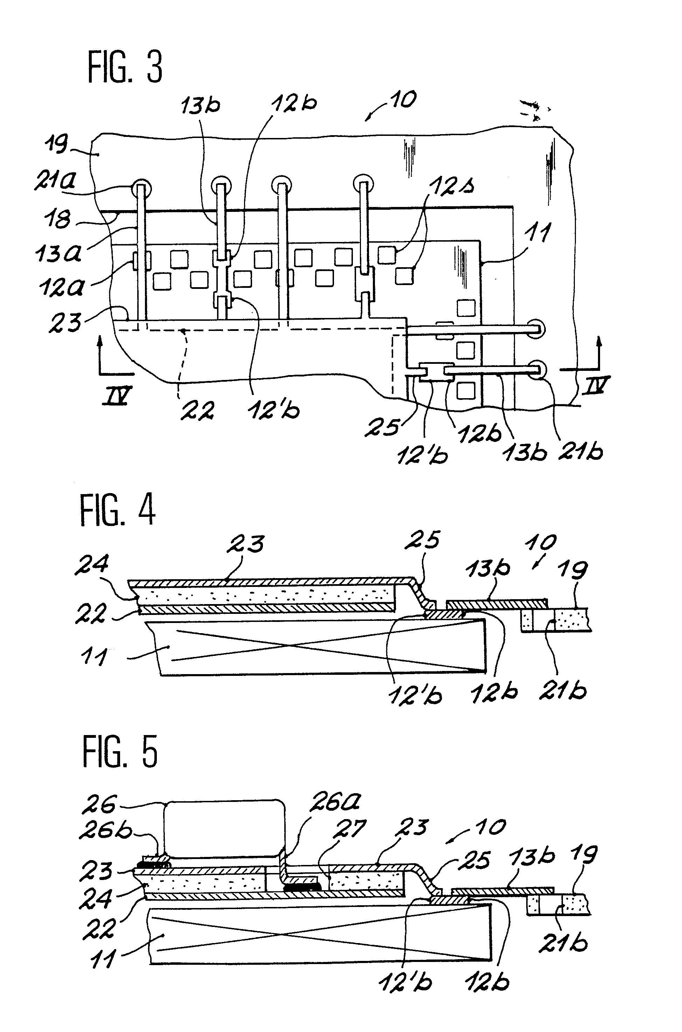

Les figures 3 et 4 illustrent une variante conforme à l'invention d'un support TAB. Cette variante apporte un perfectionnement au mode de réalisation représenté sur les figures 1 et 2. Ainsi, dans les figures 3 et 4, les pattes d'alimentation 13a sont réunies par le pont conducteur 22 de la manière représentée sur les figures 1 et 2, tandis que les pattes d'alimentation 13b sont aussi réunies à un second pont conducteur 23 placé dans la région centrale 18 du cadre 19. Pour la commodité du dessin, les pattes de signaux 13s ont été omises. Dans l'exemple illustré, le pont 23 recouvre le pont 22 par l'intermédiaire d'une couche d'isolation 24 et présente des jambes périphériques 25 en correspondance avec les pattes d'alimentation 13b de l'araignée 14. Le circuit intégré 11 selon cette variante se caractérise par le fait que les bornes d'alimentation 12b présentent chacune une surface permettant leur connexion respective aux pattes d'alimentation 13b et aux jambes 25 du second pont conducteur 23. Avantageusement, les bornes 12b gardent leur conformation traditionnelle (en quinconce avec les autres bornes 12a, 12s dans l'exemple illustré) pour la connexion ILB avec les pattes 13b et se prolongent vers l'intérieur du circuit intégré pour former une plage de connexion 12'b pour les jambes 25. Selon cette variante, les deux potentiels d'alimentation Ua et Ub sont appliqués respectivement aux deux plans conducteurs 22, 23 dans la région centrale 18 du cadre 19.

D'une manière générale, il est évident que la connexion du second pont conducteur 23 peut se faire sur une partie seulement du nombre des bornes 12b. Il est tout aussi évident que les deux ponts conducteurs 22, 23 peuvent être affectés respectivement aux potentiels d'alimentation Ua et Ub. La structure des deux ponts 22, 23 sur le circuit intégré 11 tel qu'illustré dans la figure 4 et appliqué au boîtier 50 permettrait de supprimer au moins en partie les plans conducteurs 59a, 59b. Par exemple, la partie restante ne servirait que pour le montage des condensateurs.

La figure 5 est une vue similaire à celle de la figure 4 et illustre une variante de réalisation conforme à l'invention, consistant en un perfectionnement du support 10 tel que représenté sur les figures 3 et 4. Selon cette variante, au moins un condensateur de découplage 26 est disposé sur le pont conducteur 23. La borne 26a du condensateur 26 est mise au potentiel Ua par une soudure faite sur le pont conducteur 22 dans une cavité 27 ménagée dans le second pont conducteur 23 et la couche d'isolation 24. L'autre borne 26b du condensateur 26 est directement soudée sur le second pont conducteur 23.

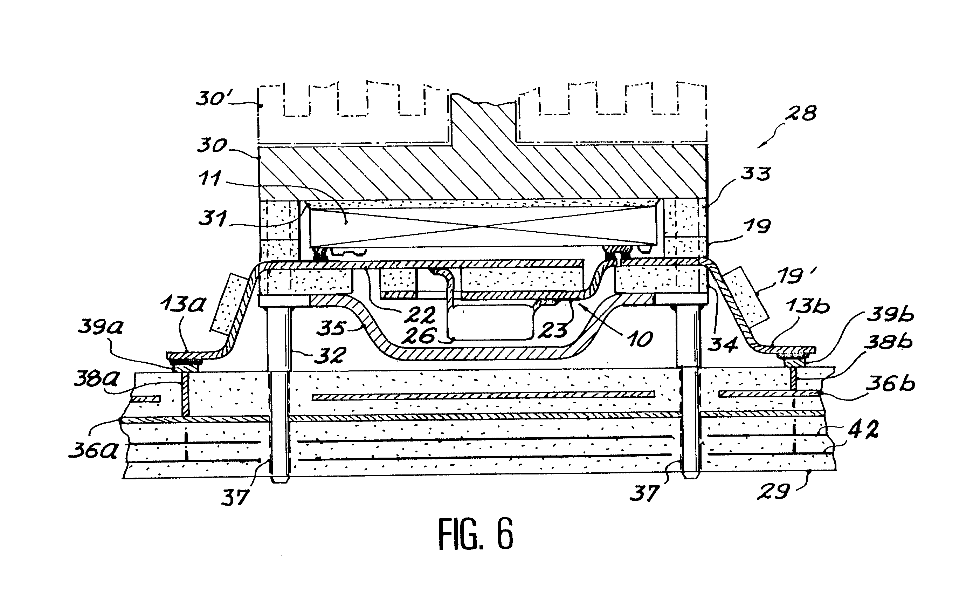

La figure 6 est une vue en coupe d'un boîtier 28 conforme à l'invention, incorporant le circuit intégré 11 représenté sur les figures 3 et 4 et une variante d'exécution conforme à l'invention du support 10 représenté sur la figure 5. Le boîtier 28 est illustré en position finale de montage sur une carte d'interconnexion 29. Le boîtier 28 inclut une embase 30 faite en un matériau électriquement et thermiquement conducteur, tel que le cuivre ou l'aluminium. L'embase 30 illustrée porte une colonne axiale pour la fixation d'un radiateur 30'. Le circuit intégré 11 a sa base fixée sur l'embase 30 par un ciment conducteur 31, en époxy par exemple. Le circuit intégré 11 est associé à un support 10 pourvu de deux ponts conducteurs 22, 23 et d'au moins un condensateur 26, tel que le support 10 représenté sur la figure 5. Cependant, toutes les pattes 13 de l'araignée du support 10 de la figure 6 ont la même longueur et le cadre 19 est limité à une bande étroite autour du circuit intégré 11. Le cadre 19 ne porte pas de trous comme les trous 21 dans le cadre 19 du support 10 de la figure 1. Les extrémités extérieures des pattes 13 sont portées par un second cadre 19'. L'embase 30 comporte quatre pieux 32 fixés dans ses quatre coins et adaptés pour s'enficher dans la carte 29. Le support 10 est maintenu enserré dans le boîtier par deux cadres isolants 33, 34 montés sur les pieux 32. Un couvercle 35 est fixé aux pieux 32. La carte 29 est du type carte de circuits imprimés, incluant deux plans 36a et 36b d'amenée des potentiels d'alimentation Ua et Ub et un réseau d'interconnexion de signaux 42. Le plan de masse 36a est connecté aux trous 37 dans lesquels les pieux 32 sont enfichés. Les plans 36a et 36b sont aussi connectés par l'intermédiaire de piliers 38a, 38b à des plages extérieures 39a, 39b pour la connexion respective des pattes d'alimentation 13a, 13b du support 10. Les pattes de signaux 13s (cachées par les pattes d'alimentation illustrées) sont fixées à des plages correspondantes 39s (elles aussi cachées) reliées par des piliers (représentés par un trait tireté) au réseau d'interconnexion de signaux 42. L'avantage du boîtier 28 est d'être très compact et facilement réalisable au moindre coût, et d'avoir un dispositif de découplage efficace.

En variante, les pieux 32 pourraient être éliminés, dans le cas où par exemple l'embase 30 serait mise à la masse par le dispositif de refroidissement adapté au boîtier. D'autre part, l'embase 30 et le cadre isolant 33 pourraient ne faire qu'un seul bloc. Bien entendu, le support 10 pourrait aussi comporter la base 40 représentée sur la figure 2. Bien entendu, de nombreuses variantes pourraient encore être apportées aux boîtiers 28 et 50, ainsi qu'aux supports 10 tels qu'illustrés. Notamment, le cadre 19 peut être formé sur l'autre face de l'araignée TAB 14. Ainsi, dans le boîtier 28, il se substituerait au cadre isolant 34. Le cadre 19' concentrique serait disposé aussi du côté du cadre 19 modifié.

## Revendications

1. Support TAB (10) d'un circuit intégré (11), comprenant une pluralité (14) de pattes (13) destinées à être connectées au circuit intégré dans une région (18) du support, caractérisé en ce que parmi les pattes (13) un premier groupe prédéterminé de pattes (13a) sensiblement inférieur à ladite pluralité est relié dans la région (18), en une position prévue au-dessus du circuit intégré, à un premier pont conducteur (22).

2. Support selon la revendication 1, caractérisé en ce que les pattes (13a) dudit premier groupe se prolongent vers l'intérieur de la région (18) pour être connectées au pont (22).

3. Support selon la revendication 1 ou 2, caractérisé en ce que les pattes (13a) sont destinées à recevoir un premier potentiel d'alimentation (Ua).

4. Support selon la revendication 1, 2 ou 3, caractérisé en ce que le pont (22) couvre sensiblement la surface de la région (18).

5. Support selon l'une des revendications 1 à 4, caractérisé en ce que le pont (22) porte une base isolante (40) destinée à venir en appui contre la face active du circuit intégré (11).

6. Support selon la revendication 5, caractérisé en ce que la base isolante (40) est percée de trous (41) au-dessous des pattes pour le soudage ILB.

7. Support selon l'une des revendications 1 à 6, caractérisé en ce qu'un second pont conducteur (23) est fixé par l'intermédiaire d'une couche d'isolation (24) sur le premier pont conducteur (22) et comporte des jambes (25) connectées au circuit intégré (11) pour être reliées à un second groupe de pattes (13b) de ladite pluralité, différent dudit premier groupe.

8. Support selon la revendication 7, caractérisé en ce que les pattes (13b) du second groupe sont destinées à recevoir un second potentiel d'alimentation (Ub).

9. Support selon la revendication 6, 7 ou 8, caractérisé en ce qu'au moins une cavité (27) est ménagée dans le second pont (23) et la couche d'isolation (24) pour mettre à nu une région du premier pont.

10. Support selon la revendication 9, caractérisé en ce que le second pont porte au moins un condensateur de découplage (26) ayant une borne (26b) connectée au second pont (23) et l'autre borne (26a) connectée au premier pont (22) au travers de la cavité (27).

11. Circuit intégré (11) pour la réalisation du support (10) selon l'une des revendications 7 à 10, comprenant des bornes d'alimentation (12a, 12b) et des bornes de signaux (12s), caractérisé en ce que certaines bornes d'alimentation présentent chacune une surface (12b, 12′b) permettant la connexion ILB et la fixation des jambes du second pont conducteur.

12. Procédé de fabrication d'un support (10) de circuit intégré (11) tel que défini par l'une des revendications 1 à 10, comprenant la formation dans une feuille conductrice d'une pluralité (14) de pattes (13) convergeant dans une région (18) pour être fixées au circuit intégré, caractérisé en ce qu'il consiste à prolonger dans la région (18) un premier groupe de pattes (13a) de ladite pluralité et à les réunir dans la région à un pont conducteur (22).

13. Procédé selon la revendication 12, caractérisé en ce qu'il consiste à placer une base isolante (40) entre le circuit intégré et le pont conducteur.

14. Procédé selon la revendication 13, comprenant la conformation du substrat isolant (15) qui porte ladite pluralité de pattes dans le support (10), caractérisé en ce qu'il consiste à laisser sous le pont (22) une base isolante (40) issue du substrat isolant.

15. Procédé selon la revendication 13 ou 14, caractérisé en ce qu'il consiste à étendre et fixer la base isolante sous la pluralité de pattes, et à former un trou sous chaque patte pour la connexion ILB.

16. Boîtier (50) de circuit intégré (11) monté sur un support TAB (10), comprenant au moins deux plans conducteurs de potentiel (59a, 59b) extérieurs au circuit intégré, caractérisé en ce que le support est celui défini par l'une des revendications 1 à 10.

17. Boîtier (28) de circuit intégré (11) monté sur un support TAB (10), comprenant une embase (30) supportant le circuit intégré et le support TAB, caractérisé en ce que le circuit intégré est celui défini par la revendication 11 et le support TAB est celui défini par la revendication 10, sur lequel la pluralité (14) de pattes (13) s'étend à l'extérieur du boîtier pour être connectées à des plages correspondantes (39) d'une carte d'interconnexion (29).

## FIG. 1

FIG. 2

FIG. 3

FIG. 4

FIG. 5

FIG. 6

EP 0 368 741 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 239 494  (BULL)<br>* Figures 1,5; revendication 1; page 8, lignes 2-5 * | 1 | H 01 L   23/498<br>H 01 L   23/64 |
| A | | 10,17 | |
| | --- | | |
| Y | DE-A-3 036 439  (SIEMENS)<br>* Figures 4,9; revendication 1 * | 1 | |
| A | | 2,4 | |
| | --- | | |
| A | EP-A-0 285 277  (AMP)<br>--- | | |
| A | IBM TECHNICAL DISCLOSURE BULLETIN, vol. 21, no. 5, octobre 1978, pages 1895-1897, New York, US; S. MAGDO: "Low inductance module"<br>----- | | |

DOMAINES TECHNIQUES
RECHERCHES (Int. Cl.5)

H 01 L

Le présent rapport a été établi pour toutes les revendications

| Lieu de la recherche | Date d'achèvement de la recherche | Examinateur |
|---|---|---|
| LA HAYE | 12-01-1990 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)